# EUROPEAN PATENT APPLICATION

(11) **EP 4 827 277 A1**
(43) Date of publication of application: **21.10.2026**
(21) Application number: 26172342.3
(22) Date of filing: 14.04.2026
(51) Int. Cl.: H10F 19/80, H10F 77/45

(54) **PHOTOVOLTAIC MODULE**

(30) Priority: 16.04.2025 CN 202510479650
(71) Applicant: TONGWEI SOLAR (HEFEI) CO., LTD., Hefei, Anhui 230088 (CN)
(72) Inventor: CHENG, Yongmeng, Hefei 230088 (CN); GAO, Han, Hefei 230088 (CN); GUO, Yiwei, Hefei 230088 (CN); DING, Changlin, Hefei 230088 (CN); XIA, Zhengyue, Hefei 230088 (CN)
(74) Representative: Murgitroyd & Company

(57) **Abstract**

The present application provides a photovoltaic module, at least including a front glass (100), a front encapsulation film (200), a cell string (300), and a back encapsulation film (400) arranged in sequence. At least a part of the back encapsulation film (400) includes an oxygen barrier encapsulation film (410), and the oxygen barrier encapsulation film (410) is used to provide oxygen barrier for the front encapsulation film (200). The oxygen barrier encapsulation film (410) includes: an oxygen barrier material layer (411) including a first surface and a second surface opposite to each other; and an encapsulation material layer (412) bonded to the first surface and/or the second surface of the oxygen barrier material layer (411), and used to bond the oxygen barrier encapsulation film (410) to the cell string (300).

## Description

### TECHNICAL FIELD

The present application relates to the field of photovoltaic technologies, and in particular, to a photovoltaic module.

### BACKGROUND

Solar cells are devices that directly convert light energy into electrical energy through photovoltaic effect or photochemical effect. As long as they are exposed to light, they can instantly output voltage and current. In physics, this is referred to as solar photovoltaic (Photovoltaic, PV), or simply photovoltaic.

Solar cells face many challenges in practical applications, one of the main difficulties being ultraviolet light-induced degradation. Taking heterojunction (HJT) cells and tunnel oxide passivated contact (TOPCon) cells as examples, ultraviolet light destroys silicon-hydrogen bonds (Si-H) in the cells, thereby leading to passivation failure and thus reducing cell efficiency. Conventional solutions include using a cutoff encapsulation film to filter ultraviolet light or using a light conversion encapsulation film to convert ultraviolet light into visible light. Among these, using the light conversion encapsulation film may also improve light utilization efficiency compared to using the cutoff encapsulation film. However, during the use of the light conversion encapsulation film, the efficiency of the solar cells continues to decrease.

### SUMMARY

Based on this, it is necessary to address the problems in the above background technology and provide a photovoltaic module that may at least avoid ultraviolet light-induced degradation, improve the conversion efficiency of the photovoltaic module, and extend the service life of the photovoltaic module.

To achieve the above objectives and other related objectives, one aspect of the present application provides a photovoltaic module, the photovoltaic module at least includes a front glass, a front encapsulation film, a cell string, and a back encapsulation film arranged in sequence. At least a part of the back encapsulation film includes an oxygen barrier encapsulation film, the oxygen barrier encapsulation film is used to provide oxygen barrier for the front encapsulation film, and the oxygen barrier encapsulation film includes an oxygen barrier material layer and an encapsulation material layer. The oxygen barrier material layer includes a first surface and a second surface opposite to each other, and the encapsulation material layer is bonded to the first surface and/or the second surface of the oxygen barrier material layer for bonding the oxygen barrier encapsulation film to the cell string.

In one embodiment, the front encapsulation film includes a light conversion encapsulation film, the light conversion encapsulation film is used to convert a first wavelength light into a second wavelength light, and the first wavelength light and the second wavelength light have different wavelengths.

In one embodiment, the light conversion encapsulation film is at least used to convert ultraviolet light into visible light.

In one embodiment, the cell string includes a light-aging cell, a service life of the light-aging cell under the first wavelength light is shorter than a service life of the light-aging cell under the second wavelength light; and/or, the cell string includes a light-induced degradation cell, and a conversion efficiency of the light-induced degradation cell under the first wavelength light is lower than a conversion efficiency of the light-induced degradation cell under the second wavelength light.

In one embodiment, the light-aging cells and/or the light-induced degradation cells include at least one of a heterojunction cell and a tunnel oxide passivated contact cell.

In one embodiment, the light conversion encapsulation film includes an encapsulation material layer and a light conversion agent, the light conversion agent is dispersed in the encapsulation material layer, and the light conversion agent is used to convert the first wavelength light into the second wavelength light.

In one embodiment, the light conversion agent includes an organic fluorescent compound, and the oxygen barrier encapsulation film is used to provide oxygen barrier for the light conversion agent.

In one embodiment, the oxygen barrier material layer includes at least one of ethylene-vinyl alcohol copolymer and polyvinyl alcohol.

In one embodiment, the encapsulation material layer includes a single-layer structure or a stacked structure, the encapsulation material layer includes at least one of an ethylene-vinyl acetate copolymer layer and a polyolefin elastomer layer.

In one embodiment, a thickness of the oxygen barrier material layer ranges from 0.01 mm to 0.1 mm, and a thickness of the encapsulation material layer ranges from 0.2 mm to 0.8 mm.

In one embodiment, the encapsulation material layer further includes a water barrier material layer, and the water barrier material layer is at least used to provide water barrier for the front encapsulation film.

In one embodiment, the photovoltaic module further includes a back glass, the back glass is located on a side, away from the cell string, of the back encapsulation film, and the back glass is capable of providing oxygen barrier. Or,

In another embodiment, the photovoltaic module further includes a backsheet, the backsheet is located on a side, away from the cell string, of the back encapsulation film, and the backsheet is oxygen-permeable.

In one embodiment, at least one opening area is located on the back glass, and the oxygen barrier encapsulation film is at least located on an inner side of the opening area.

In one embodiment, a size of the oxygen barrier encapsulation film is larger than a size of the opening area, and the oxygen barrier encapsulation film completely covers the opening area.

In one embodiment, the oxygen barrier encapsulation film is at least located on an edge area of the back encapsulation film.

In one embodiment, the back encapsulation film includes an encapsulation film and the oxygen barrier encapsulation film. The encapsulation film at least includes an encapsulation material layer, the encapsulation film covers the cell string, the oxygen barrier encapsulation film is bonded to the encapsulation film, the oxygen barrier encapsulation film and the encapsulation film are laminated to form the back encapsulation film.

In one embodiment, a width of the oxygen barrier encapsulation film located on the edge area of the back encapsulation film ranges from 10 mm to 50 mm, the oxygen barrier encapsulation film is arranged overlapping with the encapsulation film, and a width of an overlapping area of the oxygen barrier encapsulation film and the encapsulation film ranges from 3 mm to 10 mm.

In one embodiment, the oxygen barrier encapsulation film is located on a side, away from the cell string, of the encapsulation film.

In one embodiment, the oxygen barrier encapsulation film completely covers the backsheet.

### BRIEF DESCRIPTION OF THE DRAWINGS

To better describe and illustrate the embodiments and/or examples of the applications disclosed herein, reference may be made to one or more of the accompanying drawings. Additional details or examples used to describe the accompanying drawings should not be considered as limiting the scope of any of the disclosed applications, the currently described embodiments and/or examples, or the best mode currently understood for these applications.
FIG. 1 is a schematic structural diagram of a photovoltaic module according to an embodiment;
FIG. 2A is a schematic structural diagram of an oxygen barrier encapsulation film according to an embodiment;
FIG. 2B is a schematic structural diagram of another oxygen barrier encapsulation film according to an embodiment;
FIG. 2C is a schematic structural diagram of still another oxygen barrier encapsulation film according to an embodiment;
FIG. 3 is a schematic structural diagram of a back encapsulation film according to an embodiment;
FIG. 4 is a schematic structural diagram of a photovoltaic module according to another embodiment;
FIG. 5 is a schematic structural diagram of a photovoltaic module according to still another embodiment.

### Reference numeral description:

100. front glass; 200. front encapsulation film; 300. cell string; 400. back encapsulation film; 410. oxygen barrier encapsulation film; 411. oxygen barrier material layer; 412. encapsulation material layer; 420. encapsulation film; 500. back glass; 501. opening area; 600. backsheet.

### DETAILED DESCRIPTION OF THE EMBODIMENTS

To facilitate understanding of the present application, a more comprehensive description of the present application will be provided below with reference to the accompanying drawings. Preferred embodiments of the present application are shown in the accompanying drawings. However, the present application may be implemented in many different forms and is not limited to the embodiments described herein. On the contrary, the purpose of providing these embodiments is to make the disclosure of the present application more thorough and comprehensive.

Solar cells face many challenges in practical applications, one of the main difficulties being ultraviolet light-induced degradation. Taking heterojunction (HJT) cells and tunnel oxide passivated contact (TOPCon) cells as examples, ultraviolet light destroys silicon-hydrogen bonds (Si-H) in the cells, thereby leading to passivation failure and thus reducing cell efficiency. Conventional solutions include using a cutoff encapsulation film to filter ultraviolet light or using a light conversion encapsulation film to convert ultraviolet light into visible light. Among these, using the light conversion encapsulation film may also improve light utilization efficiency compared to using the cutoff encapsulation film. However, during the use of the light conversion encapsulation film, the efficiency of the solar cells continues to decrease.

By researching and analyzing the problem that the efficiency of the solar cells continues to decrease during the use of a light conversion encapsulation film, it has been found that oxidation is an important cause of the reduced efficiency of the light conversion encapsulation film. Particularly, when oxygen in the air oxidizes a light conversion agent in the light conversion encapsulation film, it causes the light conversion encapsulation film to fail, which in turn leads to ultraviolet light-induced degradation of the solar cells. Therefore, it is necessary to provide oxygen barrier protection for the light conversion encapsulation film.

Further analysis of the photovoltaic module using the light conversion encapsulation film has revealed that the degree of oxidation varies in different areas of the light conversion encapsulation film. Research indicates that the main cause of oxidation of the light conversion encapsulation film is the intrusion of oxygen from a backside of the photovoltaic module, particularly at openings such as wiring holes provided on the backside of the photovoltaic module, the degree of oxidation of the light conversion encapsulation film at the corresponding positions is significantly higher than in other areas. Therefore, it is necessary to provide oxygen barrier protection for the areas of the light conversion encapsulation film that are prone to oxidation.

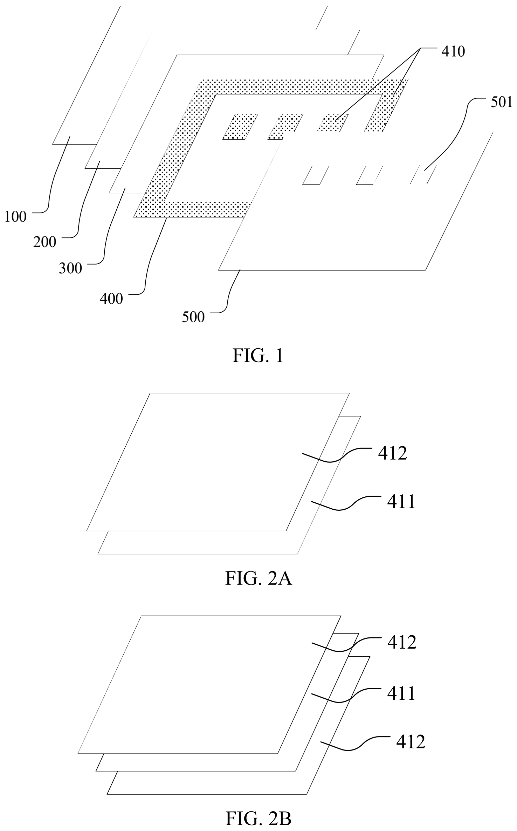

Based on the above research and analysis, the present application provides a photovoltaic module. Referring to FIGs. 1, 4, 5, and FIGs. 2A-2C, the photovoltaic module at least includes a front glass 100, a front encapsulation film 200, a cell string 300, and a back encapsulation film 400 arranged in sequence. Among them, at least a part of the back encapsulation film 400 includes an oxygen barrier encapsulation film 410, and the oxygen barrier encapsulation film 410 is used to provide oxygen barrier for the front encapsulation film 200.

The oxygen barrier encapsulation film 410 includes an oxygen barrier material layer 411 and an encapsulation material layer 412. The oxygen barrier material layer 411 includes a first surface and a second surface opposite to each other. The encapsulation material layer 412 is bonded to the first surface and/or the second surface of the oxygen barrier material layer 411, and used to bond the oxygen barrier encapsulation film 410 to the cell string 300.

According to the photovoltaic module provided in the present application, by using the oxygen barrier encapsulation film as at least a part (the whole or a part) of the back encapsulation film to provide oxygen barrier for the front encapsulation film, the light conversion encapsulation film located on the front side of the cell string is prevented from being oxidized by oxygen entering from the back side, which would otherwise cause functional failure and aging of the light conversion encapsulation film. This further prevents the cell string from experiencing ultraviolet light-induced attenuation and aging, thereby improving the conversion efficiency of the photovoltaic module and extending the service life of the photovoltaic module.

Referring to FIG. 1, the photovoltaic module at least includes a front glass 100, a front encapsulation film 200, a cell string 300, a back encapsulation film 400, and a back glass 500 arranged in sequence. Among them, a part of the back encapsulation film 400 includes an oxygen barrier encapsulation film 410, and the oxygen barrier encapsulation film 410 is used to provide oxygen barrier for the front encapsulation film 200.

Referring to FIGs. 2A-2C, the oxygen barrier encapsulation film 410 includes an oxygen barrier material layer 411 and an encapsulation material layer 412. The oxygen barrier material layer 411 includes a first surface and a second surface opposite to each other. The encapsulation material layer 412 is bonded to the first surface and/or the second surface of the oxygen barrier material layer 411 for bonding the oxygen barrier encapsulation film 410 to the cell string 300 and the back glass 500.

For example, the cell string 300 includes a light-aging cell. A service life of the light-aging cell under the first wavelength light is shorter than a service life of the light-aging cell under the second wavelength light; and/or, the cell string includes a light-induced degradation cell. A conversion efficiency of the light-induced degradation cell under the first wavelength light is lower than a conversion efficiency of the light-induced degradation cell under the second wavelength light. The first wavelength light and the second wavelength light having different wavelengths. Typically, the wavelength of the first wavelength light is shorter than the wavelength of the second wavelength light. Specifically, the wavelength of the first wavelength light ranges from 280 nm to 500 nm, and the wavelength of the second wavelength light ranges from 380 nm to 800 nm. For example, the first wavelength light includes ultraviolet light, and the second wavelength light includes visible light.

In one embodiment, the light-aging cell and/or the light-induced degradation cell includes, but is not limited to, at least one of a heterojunction (HJT) cell or a tunnel oxide passivated contact (TOPCon) cell. For the heterojunction (HJT) cell, an amorphous silicon layer (a-Si) is present on its surface. As the amorphous silicon layer of a passivation layer, it contains a large number of silicon-hydrogen (Si-H) bonds, which are susceptible to breakage upon exposure to ultraviolet radiation, thereby leading to defects in the internal structure and built-in electric field of the heterojunction (HJT) cell. This further causes power attenuation and shortened service life of the heterojunction (HJT) cell. For the tunnel oxide passivated contact (TOPCon) cell, ultraviolet light damages the silicon-hydrogen (Si-H) bonds in the passivation layer, thereby leading to passivation failure and reducing cell efficiency. This damage mainly occurs in the tunnel oxide layer (SiOx) and the doped polysilicon layer. Front surface passivation is provided by the combined action of aluminum oxide (AlOx) and silicon nitride (SiN). Ultraviolet light irradiation breaks the hydrogen bonds, increases electron-hole pair recombination, and reduces open-circuit voltage (VOC) and fill factor (FF). Rear surface passivation relies on the chemical passivation of the tunnel oxide layer and the field-effect passivation of the doped polysilicon layer. Ultraviolet light induces the out-diffusion of hydrogen from the tunnel oxide layer, leading to chemical passivation failure and exacerbating rear surface degradation, thereby causing power attenuation and shortened service life of the tunnel oxide passivated contact (TOPCon) cell.

In one embodiment, in order to reduce the adverse effects of ultraviolet light on the light-aging cell and the light-induced degradation cell while ensuring light utilization, the front encapsulation film 200 of the photovoltaic module may be entirely set as a light conversion encapsulation film, meaning the light conversion encapsulation film fully covers the cell string 300. The light conversion encapsulation film is used to convert light between different wavelengths, such as converting the first wavelength light into the second wavelength light. Specifically, to address the damage to the silicon-hydrogen (Si-H) bonds caused by ultraviolet light, the light conversion encapsulation film may be used to convert ultraviolet light into visible light.

In one embodiment, the light conversion encapsulation film includes an encapsulation material layer and a light conversion agent, the light conversion agent is dispersed in the encapsulation material layer, where the light conversion agent is used to convert the first wavelength light into the second wavelength light. The light conversion encapsulation film has a high quantum efficiency, which may convert ultraviolet light into visible light, thereby avoiding efficiency attenuation caused by ultraviolet light in the photovoltaic module and improving the ultraviolet aging resistance of the photovoltaic module.

In one embodiment, the encapsulation material layer includes, but is not limited to, at least one of an EVA encapsulation film, a POE encapsulation film, or an EPE encapsulation film. The EVA encapsulation film for the photovoltaic module is a functional film primarily made from an ethylene-vinyl acetate copolymer (EVA) resin as the main raw material, by adding suitable cross-linking agents, anti-aging additives, and other components. The EVA encapsulation film has characteristics such as high light transmittance, resistance to UV and damp-heat yellowing, and strong adhesion to glass and backsheet, thereby allowing sunlight to pass through the encapsulation film to the cells to the maximum extent. The POE (polyolefin elastomer) encapsulation film for the photovoltaic module is a metallocene polyethylene elastomer polymerized from ethylene and 1-hexene or 1-octene under a metallocene catalyst system. Compared to the EVA encapsulation film, the POE encapsulation film has a more stable molecular structure, higher volume resistivity, better thermal stability, and stronger resistance to UV aging. Additionally, the water vapor transmission rate of the POE encapsulation film is only about 1/8 of that of the EVA encapsulation film, thereby effectively blocking moisture. The EPE encapsulation film, that is, an "EVA-POE-EVA" three-layer composite structured film, is produced by modifying and combining EVA material and POE material through a co-extrusion process. The EPE encapsulation film combines the advantages of the EVA encapsulation film and the POE encapsulation film, thereby providing more composite options.

In one embodiment, the light conversion agent includes but is not limited to organic fluorescent compounds, whose molecular structure contains chromophores, mostly large π-conjugated structures with benzene rings or other aromatic rings. The light conversion encapsulation film tends to yellow and degrade under ultraviolet light irradiation due to oxidation of the light conversion agent, thereby leading to yellowing and degradation of the light conversion performance. In order to prevent the light conversion agent from being oxidized, the back encapsulation film 400 may be set to an oxygen barrier encapsulation film 410, so that the oxygen barrier encapsulation film 410 provides oxygen barrier for the light conversion agent.

In one embodiment, the oxygen barrier encapsulation film 410 at least includes an oxygen barrier material layer 411 and an encapsulation material layer 412. The oxygen barrier material layer 411 includes but is not limited to at least one of ethylene-vinyl alcohol copolymer (EVOH) or polyvinyl alcohol (PVA). The encapsulation material layer 412 includes but is not limited to at least one of an EVA encapsulation film, a POE encapsulation film, or an EPE encapsulation film, which will not be further elaborated here. Optionally, the oxygen barrier encapsulation film 410 also includes a water barrier material layer, the water barrier material layer includes but is not limited to polyolefin elastomer (POE). When the water barrier material layer is provided with the oxygen barrier encapsulation film 410, it may provide water and humidity barrier for the front encapsulation film 200 and the cell string 300, thereby improving the performance of the photovoltaic module. Additionally, it should be noted that in high-humidity environments, it is generally necessary to use the oxygen barrier material layer 411 in combination with the water barrier material layer to ensure the oxygen barrier effect of the oxygen barrier material layer 411. For example, in a low-humidity environment, using EVOH or PVA as the oxygen barrier material layer results in an extremely low oxygen transmission rate. However, in a high-humidity environment, EVOH or PVA materials absorb moisture, thereby leading to an increased oxygen transmission rate. Therefore, it is necessary to maintain the oxygen barrier material layer 411 in a relatively low-humidity environment to ensure that the oxygen barrier material layer 411 has good oxygen barrier performance. Moreover, since polyolefin elastomer (POE) functions both as an encapsulation material and a water barrier material, a POE layer may serve as either an encapsulation material layer or a water barrier material layer, or simultaneously provide both encapsulating and water barrier functions.

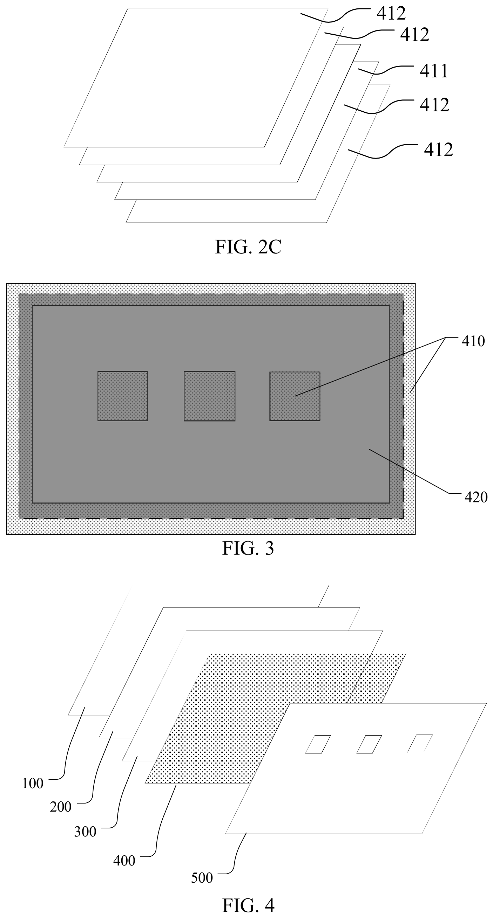

In one embodiment, the encapsulation material layer 412 is bonded to the first surface and/or a second surface of the oxygen barrier material layer 411 to form the oxygen barrier encapsulation film 410. Referring to FIG. 2A, when the encapsulation material layer 412 is bonded only to one of the surfaces of the oxygen barrier material layer 411, an encapsulation material layer-oxygen barrier material layer structure may be formed, such as EVA-EVOH, POE-EVOH, EPE-EVOH, PVA-EVA, PVA-POE, or PVA-EPE, and so on. Referring to FIG. 2B, when the encapsulation material layer 412 is bonded to both surfaces of the oxygen barrier material layer 411, a first encapsulation material layer-oxygen barrier material layer-second encapsulation material layer structure may be formed, where the first encapsulation material layer and the second encapsulation material layer may be the same or different, such as EVA-EVOH-EVA, POE-EVOH-POE, EVA-EVOH-POE, EVA-PVA-EVA, POE-PVA-POE, or POE-PVA-EVA, and so on. Referring to FIG. 2C, the encapsulation material layer 412 may not only be a single-layer structure but also a stacked structure, and the numbers of layers of the encapsulation material layer 412 bonded to the first surface and the second surface of the oxygen barrier material layer 411 may be the same or different, such as POE-EVA-EVOH-POE-EVA, EPE-EVOH-EPE, EVA-EVOH-POE-EVA, POE-EVOH-EPE, EVA-POE-PVA-POE-EVA, EPE-PVA-EPE, EVA-POE-PVA-POE, or EPE-PVA-EVA, and so on.

In one embodiment, the oxygen barrier encapsulation film may be formed by a co-extrusion molding process. For example, EVA encapsulation film particles and EVOH particles are co-extruded to form a three-layer structure, that is, an EVA-EVOH-EVA encapsulation film. A thickness of the formed EVA layers ranges from 0.2 mm to 0.8 mm and a thickness of the formed EVOH layers ranges from 0.01 mm to 0.1 mm. An interlayer adhesion between the EVA layers and the EVOH layer is greater than a preset value, for example, 0.5 N. Optionally, the oxygen barrier encapsulation film may also be formed by an extrusion coating process. For example, an EVOH single-layer film is first formed by casting, and then EVA or POE is extrusion coated onto the surface of the EVOH layer film to form a final two-layer or three-layer structure encapsulation film. Further, POE may be further extrusion coated onto the surface of the EVA layer film, or EVA extrusion coated onto the surface of the POE layer film, to generate a multiple layer encapsulation film, thereby enhancing the interlayer adhesion and anti-aging performance of the encapsulation film.

In one embodiment, the photovoltaic module includes a double-glass photovoltaic module, and the double-glass photovoltaic module includes a front glass 100, a front encapsulation film 200, a cell string 300, a back encapsulation film 400 and a back glass 500 arranged in sequence. Among them, the oxygen transmission rate of the back glass 500 is less than a preset value, and the back glass 500 may be used for providing oxygen barrier. Therefore, the back encapsulation film 400 of the double-glass photovoltaic module may partially adopt the oxygen barrier encapsulation film 410, referring to FIG. 1. For example, the back glass 500 may be a spectral glass, and the preset value may be range from 0.005 to 0.01 cm³/(cm²·s·atm).

In one embodiment, referring to FIG. 3, when the back encapsulation film 400 partially adopts the oxygen barrier encapsulation film 410, the back encapsulation film 400 is at least composed of an encapsulation film 420 and the oxygen barrier encapsulation film 410. The encapsulation film 420 covers the entirety of the cell string 300, and is used to bond the cell string 300 and the back glass 500 together. The encapsulation film 420 at least includes an encapsulation material layer, and the encapsulation material layer includes but is not limited to at least one of an EVA encapsulation film, a POE encapsulation film, and an EPE encapsulation film, which will not be repeated here.

In one embodiment, referring to FIG. 1, at least one opening area 501 is located on the back glass 500, and the oxygen barrier encapsulation film 410 is at least located on an inner side of the opening area 501. The opening area 501 includes but is not limited to functional openings such as a lead wire extraction hole, a mounting and fixing hole, and a ventilation and drainage hole, and so on. When disposing the back encapsulation film 400 at the opening area 501, the oxygen barrier encapsulation film 410 is usually located on an outer side of the encapsulation film 420, that is, on a side of the encapsulation film 420 away from the cell string 300. Further, a size of the oxygen barrier encapsulation film 410 used to cover the opening area 501 is usually larger than a size of the opening area 501, ensuring that the oxygen barrier encapsulation film 410 not only completely covers the opening area 501 but also covers a part of the back glass 500 surrounding the opening area 501, thereby improving the oxygen barrier effect. Specifically, an overlapping size between the oxygen barrier encapsulation film 410 and the back glass 500 around the opening area 501 ranges from 5 mm to 15 mm, such as 5 mm, 10 mm, or 15 mm. When the size of the opening area 501 is approximately 10 mm×10 mm or the diameter is about 10 mm, the size of the oxygen barrier encapsulation film 410 used to cover the opening area 501 may be 25 mm×30 mm or 30 mm×40 mm.

In one embodiment, referring to FIG. 3, since the edge area of the front encapsulation film 200 is more severely oxidized, the oxygen barrier encapsulation film 410 is located on an edge area of the back encapsulation film 400. A width of the oxygen barrier encapsulation film 410 located on the edge area of the back encapsulation film 400 ranges from 10 mm to 50 mm, and a width of an overlapping area of the oxygen barrier encapsulation film 410 and the encapsulation film 420 ranges from 3 mm to 10 mm.

In one embodiment, the back encapsulation film 400 may be formed through a lamination process. For example, first, an encapsulation film 420 for entirely covering the cell string 300 is provided. Referring to FIG. 3, the oxygen barrier encapsulation film 410 is disposed at a position on the encapsulation film 420 corresponding to the opening area 501 of the back glass 500, and the oxygen barrier encapsulation film 410 is disposed on an edge area of the encapsulation film 420. An edge of the oxygen barrier encapsulation film 410 extends beyond an edge of the encapsulation film 420. The encapsulation film and the oxygen barrier encapsulation film 410 are laminated to form the back encapsulation film 400. When forming the photovoltaic module, the encapsulation film 420 is placed close to the cell string 300 and the oxygen barrier encapsulation film 410 is placed close to the back glass 500 for encapsulation.

In one embodiment, the front encapsulation film 200 may include a light conversion encapsulation film and the oxygen barrier encapsulation film 410. For example, the oxygen barrier encapsulation film 410 completely covers the light conversion encapsulation film, and the oxygen barrier encapsulation film 410 is disposed on a side of the light conversion encapsulation film away from the cell string 300. Optionally, the oxygen barrier encapsulation film 410 may also cover only a part of the light conversion encapsulation film. For example, the oxygen barrier encapsulation film 410 is disposed on an edge area of the front encapsulation film 200. A width of the oxygen barrier encapsulation film 410 disposed on the edge area of the front encapsulation film 200 ranges from 10 mm to 50 mm, and a width of an overlapping area of the oxygen barrier encapsulation film 410 and the light conversion encapsulation film ranges from 3 mm to 10 mm. The front encapsulation film 200 may be formed by laminating the light conversion encapsulation film and the oxygen barrier encapsulation film 410, which will not be further elaborated here.

According to the photovoltaic module provided in the present application, by using the oxygen barrier encapsulation film as a part of the back encapsulation film to provide oxygen barrier for the front encapsulation film, the light conversion encapsulation film located on the front side of the cell string is prevented from being oxidized by oxygen invading from the openings and edges on the back side, which could cause functional failure and aging of the light conversion encapsulation film. This in turn prevents the cell string from undergoing ultraviolet light-induced degradation and aging, thereby improving the conversion efficiency of the photovoltaic module and extending the service life of the photovoltaic module.

In at least one embodiment of the present application, referring to FIG. 4, the photovoltaic module at least includes a front glass 100, a front encapsulation film 200, a cell string 300, a back encapsulation film 400, and a back glass 500 arranged in sequence. The back encapsulation film 400 entirely includes an oxygen barrier encapsulation film 410, and the oxygen barrier encapsulation film 410 is used to provide oxygen barrier for the front encapsulation film 200.

Referring to FIGs. 2A-2C, the oxygen barrier encapsulation film 410 includes an oxygen barrier material layer 411 and an encapsulation material layer 412. The oxygen barrier material layer 411 includes a first surface and a second surface opposite to each other. The encapsulation material layer 412 is bonded to the first surface and/or the second surface of the oxygen barrier material layer 411 to bond the oxygen barrier encapsulation film 410 to the cell string 300.

In one embodiment, the cell string 300 includes a light-aging cell. A service life of the light-aging cell under the first wavelength light is shorter than a service life of the light-aging cell under the second wavelength light; and/or, the cell string includes a light-induced degradation cell, and a conversion efficiency of the light-induced degradation cell under the first wavelength light is lower than a conversion efficiency of the light-induced degradation cell under the second wavelength light. The light-aging cell and/or the light-induced degradation cell include but is not limited to at least one of a heterojunction (HJT) cell and a tunnel oxide passivated contact (TOPCon) cell. And the first wavelength light and the second wavelength light have different wavelengths. Typically, the wavelength of the first wavelength light is shorter than that of the second wavelength light. Specifically, the wavelength of the first wavelength light ranges from 280 nm to 500 nm, and the wavelength of the second wavelength light ranges from 380 nm to 800 nm. For example, the first wavelength light includes ultraviolet light, and the second wavelength light includes visible light.

In one embodiment, in order to reduce the adverse effects of ultraviolet light on the light-aging cell and the light-induced degradation cell while ensuring light utilization, the front encapsulation film 200 of the photovoltaic module may be entirely set as a light conversion encapsulation film, that is, the light conversion encapsulation film entirely covers the cell string 300. The light conversion encapsulation film includes an encapsulation material layer and a light conversion agent, the light conversion agent is dispersed in the encapsulation material layer. The encapsulation material layer includes but is not limited to at least one of an EVA encapsulation film, a POE encapsulation film, and an EPE encapsulation film. The light conversion agent includes but is not limited to organic fluorescent compounds, whose molecular structure contains chromophores, mostly large π-conjugated structures with benzene rings or other aromatic rings. In order to prevent the light conversion agent from being oxidized, the back encapsulation film 400 may be set to an oxygen barrier encapsulation film 410, so that the oxygen barrier encapsulation film 410 provides oxygen barrier for the light conversion agent.

In one embodiment, the photovoltaic module includes a double-glass photovoltaic module, and the double-glass photovoltaic module includes a front glass 100, a front encapsulation film 200, a cell string 300, a back encapsulation film 400 and a back glass 500 arranged in sequence. An oxygen transmission rate of the back glass 500 is less than a preset value, and the back glass 500 may be used to provide oxygen barrier. Therefore, the back encapsulation film 400 of the double-glass photovoltaic module may entirely include the oxygen barrier encapsulation film 410, as shown in FIG. 4.

In one embodiment, the oxygen barrier encapsulation film 410 at least includes an oxygen barrier material layer 411 and an encapsulation material layer 412. The oxygen barrier material layer 411 includes but is not limited to at least one of ethylene-vinyl alcohol copolymer (EVOH) or polyvinyl alcohol (PVA). The encapsulation material layer 412 includes but is not limited to at least one of an EVA encapsulation film, a POE encapsulation film, and an EPE encapsulation film. Optionally, the oxygen barrier encapsulation film 410 also includes a water barrier material layer.

In one embodiment, the encapsulation material layer 412 is bonded to the first surface and/or a second surface of the oxygen barrier material layer 411 to form the oxygen barrier encapsulation film 410. Referring to FIGs. 2A-2C, the encapsulation material layer 412 may be bonded to only to one of the surfaces of the oxygen barrier material layer 411, or may be bonded to both surfaces of the oxygen barrier material layer 411. Moreover, the encapsulation material layer 412 may not only be a single-layer structure but also a stacked structure.

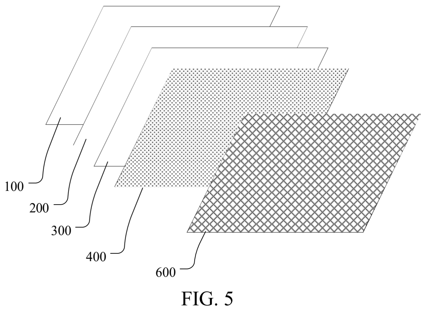

In at least one embodiment of the present application, referring to FIG. 5, the photovoltaic module at least includes a front glass 100, a front encapsulation film 200, a cell string 300, a back encapsulation film 400, and a backsheet arranged in sequence. The back encapsulation film 400 entirely includes an oxygen barrier encapsulation film 410, and the oxygen barrier encapsulation film 410 is used to provide oxygen barrier for the front encapsulation film 200.

Referring to FIGs. 2A to 2C, the oxygen barrier encapsulation film 410 includes an oxygen barrier material layer 411 and an encapsulation material layer 412. The oxygen barrier material layer 411 includes a first surface and a second surface opposite to each other. The encapsulation material layer 412 is bonded to the first surface and/or the second surface of the oxygen barrier material layer 411 to bond the oxygen barrier encapsulation film 410 to the cell string 300.

In one embodiment, the cell string 300 includes a light-aging cell. A service life of the light-aging cell under the first wavelength light is shorter than that of the light-aging cell under the second wavelength light; and/or, the cell string includes a light-induced degradation cell, and a conversion efficiency of the light-induced degradation cell under the first wavelength light is lower than that of the light-induced degradation cell under the second wavelength light. The light-aging cell and/or the light-induced degradation cell includes but is not limited to at least one of a heterojunction (HJT) cell and a tunnel oxide passivated contact (TOPCon) cell. The first wavelength light and the second wavelength light have different wavelengths. Typically, the wavelength of the first wavelength light is shorter than that of the second wavelength light. Specifically, the wavelength of the first wavelength light ranges from 280 nm to 500 nm, and the wavelength of the second wavelength light ranges from 380 nm to 800 nm. For example, the first wavelength light includes ultraviolet light, and the second wavelength light includes visible light.

In one embodiment, in order to reduce the adverse effects of ultraviolet light on the light-aging cell and the light-induced degradation cell while ensuring light utilization, the front encapsulation film 200 of the photovoltaic module may be entirely set as a light conversion encapsulation film, that is, the light conversion encapsulation film entirely covers the cell string 300. The light conversion encapsulation film includes an encapsulation material layer and a light conversion agent, the light conversion agent is dispersed in the encapsulation material layer. The encapsulation material layer includes but is not limited to at least one of an EVA encapsulation film, a POE encapsulation film, and an EPE encapsulation film. The light conversion agent includes but is not limited to organic fluorescent compounds, whose molecular structure contains chromophores, mostly large π-conjugated structures with benzene rings or other aromatic rings. In order to prevent the light conversion agent from being oxidized, the back encapsulation film 400 may be set to an oxygen barrier encapsulation film 410, so that the oxygen barrier encapsulation film 410 provides oxygen barrier for the light conversion agent.

In one embodiment, the photovoltaic module includes a single glass photovoltaic module. The single glass photovoltaic module includes a front glass 100, a front encapsulation film 200, a cell string 300, a back encapsulation film 400, and a backsheet 600 arranged in sequence. An oxygen transmission rate of the backsheet 600 is greater than a preset value, that is, when the backsheet 600 is formed of a polymer material, an oxygen transmission rate of the backsheet 600 is relatively high. Therefore, the back encapsulation film 400 of the single glass photovoltaic module needs to entirely include the oxygen barrier encapsulation film 410 to increase a coverage area of the oxygen barrier encapsulation film 410, thereby improving the oxygen barrier effect, as shown in FIG. 5.

In one embodiment, the oxygen barrier encapsulation film 410 at least includes an oxygen barrier material layer 411 and an encapsulation material layer 412. The oxygen barrier material layer 411 includes but is not limited to at least one of ethylene-vinyl alcohol copolymer (EVOH) or polyvinyl alcohol (PVA). The encapsulation material layer 412 includes but is not limited to at least one of an EVA encapsulation film, a POE encapsulation film, and an EPE encapsulation film. Optionally, the oxygen barrier encapsulation film 410 also includes a water barrier material layer.

In one embodiment, the encapsulation material layer 412 is bonded to the first surface and/or the second surface of the oxygen barrier material layer 411 to form the oxygen barrier encapsulation film 410. Referring to FIGs. 2A to 2C, the encapsulation material layer 412 may be bonded only to one of the surfaces of the oxygen barrier material layer 411, or may be bonded to both surfaces of the oxygen barrier material layer 411. Moreover, the encapsulation material layer 412 may not only be a single-layer structure but also a stacked structure.

According to the photovoltaic module provided by the present application, by using the oxygen barrier encapsulation film as at least a part of the back encapsulation film to provide oxygen barrier for the front encapsulation film, the light conversion encapsulation film located on the front side of the cell string is prevented from being oxidized by oxygen invading from the backside, which could cause functional failure and aging of the light conversion encapsulation film. This further prevents the cell string from experiencing ultraviolet light-induced attenuation and aging, thereby improving the conversion efficiency of the photovoltaic module and extending the service life of the photovoltaic module.

The above embodiments only express several implementations of the present application. The descriptions are relatively specific and detailed but should not be construed as limiting the scope of the patent application. It should be noted that for those of ordinary skill in the art, several modifications and improvements may be made without departing from the concept of the present application, all of which fall within the protection scope of the present application.

## Claims

1. A photovoltaic module, comprising a front glass (100), a front encapsulation film (200), a cell string (300), and a back encapsulation film (400) arranged in sequence, wherein at least a part of the back encapsulation film (400) comprises an oxygen barrier encapsulation film (410), the oxygen barrier encapsulation film (410) is used to provide oxygen barrier for the front encapsulation film (200), and the oxygen barrier encapsulation film (410) comprises:
an oxygen barrier material layer (411) comprising a first surface and a second surface opposite to each other; and
an encapsulation material layer (412) bonded to the first surface and/or the second surface of the oxygen barrier material layer (411), and used to bond the oxygen barrier encapsulation film (410) to the cell string (300).

2. The photovoltaic module according to claim 1, wherein the front encapsulation film (200) comprises a light conversion encapsulation film, the light conversion encapsulation film is used to convert a first wavelength light into a second wavelength light, and the first wavelength light and the second wavelength light have different wavelengths.

3. The photovoltaic module according to claim 2, wherein the light conversion encapsulation film is at least used to convert ultraviolet light into visible light.

4. The photovoltaic module according to claim 2, wherein,
the cell string (300) comprises a light-aging cell, a service life of the light-aging cell under the first wavelength light is shorter than a service life of the light-aging cell under the second wavelength light; and/or,
the cell string (300) comprises a light-induced degradation cell, and a conversion efficiency of the light-induced degradation cell under the first wavelength light is lower than a conversion efficiency of the light-induced degradation cell under the second wavelength light.

5. The photovoltaic module according to claim 2, wherein the light conversion encapsulation film comprises an encapsulation material layer and a light conversion agent, the light conversion agent is dispersed in the encapsulation material layer, and the light conversion agent is used to convert the first wavelength light into the second wavelength light.

6. The photovoltaic module according to claim 5, wherein the light conversion agent comprises an organic fluorescent compound, and the oxygen barrier encapsulation film (410) is used to provide oxygen barrier for the light conversion agent.

7. The photovoltaic module according to claim 1, wherein the encapsulation material layer (412) comprises a single-layer structure or a stacked structure, the encapsulation material layer (412) comprises at least one of an ethylene-vinyl acetate copolymer layer and a polyolefin elastomer layer.

8. The photovoltaic module according to claim 1, wherein the encapsulation material layer (412) further comprises a water barrier material layer, and the water barrier material layer is at least used to provide water barrier for the front encapsulation film (200).

9. The photovoltaic module according to claim 1, further comprising:
a back glass (500), located on a side, away from the cell string (300), of the back encapsulation film (400) and being capable of providing oxygen barrier; or,
a backsheet (600), located on a side, away from the cell string (300), of the back encapsulation film (400) and being oxygen-permeable.

10. The photovoltaic module according to claim 9, wherein at least one opening area (501) is located on the back glass (500), and the oxygen barrier encapsulation film (410) is at least located on an inner side of the opening area (501), and
a size of the oxygen barrier encapsulation film (410) is larger than a size of the opening area (501), and the oxygen barrier encapsulation film (410) completely covers the opening area (501).

11. The photovoltaic module according to claim 9, wherein the oxygen barrier encapsulation film (410) is at least located on an edge area of the back encapsulation film (400).

12. The photovoltaic module according to claim 10 or 11, wherein the back encapsulation film (400) comprises:
an encapsulation film (420), at least comprising an encapsulation material layer and covering the cell string (300); and
the oxygen barrier encapsulation film (410) bonded to the encapsulation film (420), wherein the oxygen barrier encapsulation film (410) and the encapsulation film (420) are laminated to form the back encapsulation film (400).

13. The photovoltaic module according to claim 12, wherein a width of the oxygen barrier encapsulation film (410) located on the edge area of the back encapsulation film (400) ranges from 10 mm to 50 mm, the oxygen barrier encapsulation film (410) is arranged overlapping with the encapsulation film (420), and a width of an overlapping area of the oxygen barrier encapsulation film (410) and the encapsulation film (420) ranges from 3 mm to 10 mm.

14. The photovoltaic module according to claim 12, wherein the oxygen barrier encapsulation film (410) is located on a side, away from the cell string (300), of the encapsulation film (420).

15. The photovoltaic module according to claim 9, wherein the oxygen barrier encapsulation film (410) completely covers the backsheet (600).
